# EUROPÄISCHE PATENTSCHRIFT

(11) **EP 2 583 315 B1**
(45) Veröffentlichungstag und Bekanntmachung des Hinweises auf die Patenterteilung: **14.12.2016**
(21) Anmeldenummer: 11726707.0
(22) Anmeldetag: 16.06.2011
(51) Int. Cl.: H01L 31/0216, H01L 31/18

(54) **VERFAHREN ZUR HERSTELLUNG EINER PHOTOVOLTAISCHEN SOLARZELLE MIT SELEKTIVEM EMITTER**
METHOD FOR PRODUCING PHOTOVOLTAIC SOLAR CELL WITH SELECTIVE EMITTER
PROCÉDÉ DE FABRICATION D'UNE CELLULE SOLAIRE PHOTOVOLTAÏQUE À ÉMETTEUR SÉLECTIF

(30) Priorität: 18.06.2010 DE 102010024309
(43) Veröffentlichungstag der Anmeldung: 24.04.2013
(73) Patentinhaber: Fraunhofer-Gesellschaft zur Förderung der angewandten Forschung e.V., 80686 München (DE)
(72) Erfinder: MACK, Sebastian, 79102 Freiburg (DE); JÄGER, Ulrich, 79108 Freiburg (DE); WOLF, Andreas, 79100 Freiburg (DE); BIRO, Daniel, 79106 Freiburg (DE); PREU, Ralf, 79117 Freiburg (DE); KÄSTNER, Gero, 79117 Freiburg (DE)
(86) Internationale Anmeldenummer: PCT/EP2011/002968
(87) Internationale Veröffentlichungsnummer: WO 2011/157422

(56) Entgegenhaltungen:
- US-A1- 2002 153 039
- US-A1- 2009 020 158
- US-B1- 7 615 393
- KÖHLER J R ET AL: "LASER DOPED SELECTIVE EMITTERS YIELD 0.5% EFFICIENCY GAIN", 24TH EUROPEAN PHOTOVOLTAIC SOLAR ENERGY CONFERENCE,, 21. September 2009 (2009-09-21), Seiten 1847-1850, XP007919647,
- JAEGER U ET AL: "Selective emitter by laser doping from phosphosilicate glass", EUROPEAN PHOTOVOLTAIC SOLAR ENERGY CONFERENCE AND EXHIBITION (EU PVSEC),, Bd. 24, 1. September 2009 (2009-09-01), Seiten 1740-1743, XP008144094, ISBN: 3-936338-25-6 in der Anmeldung erwähnt
- SCHINDLER R ET AL: "Single step rapid thermal diffusion for selective emitter formation and selective oxidation", 19960513; 19960513 - 19960517, 13. Mai 1996 (1996-05-13), Seiten 509-512, XP010208200,

## Beschreibung

Die Erfindung betrifft ein Verfahren zur Herstellung einer photovoltaischen Solarzelle gemäß Oberbegriff des Anspruchs 1.

Eine photovoltaische Solarzelle stellt ein flächiges Halbleiterelement dar, bei dem mittels einfallender elektromagnetischer Strahlung eine Erzeugung von Elektron-Lochpaaren erzielt wird und an mindestens einem pn-Übergang eine Ladungsträgertrennung erfolgt, so dass zwischen mindestens zwei elektrischen Kontakten der Solarzelle eine elektrische Potentialdifferenz entsteht und über einen mit diesen Kontakten verbundenen externen Stromkreis elektrische Leistung von der Solarzelle abgegriffen werden kann.

Typische Solarzellen umfassen ein Silizium-Halbleitersubstrat einer Basisdotierung, wobei in dem Halbleitersubstrat mindestens ein Emitterbereich einer Emitterdotierung, welche der Basisdotierung entgegengesetzt ist, ausgebildet ist, so dass sich zwischen Basis- und Emitterbereich der vorgenannte pn-Übergang ausbildet. Basis- und Emitterbereich sind jeweils durch mindestens eine metallische Kontaktstruktur zum Einsammeln und Abführen der Ladungsträger kontaktiert.

Zur Erzielung hoher Wirkungsgrade muss eine Optimierung hinsichtlich mehrerer Verlustmechanismen erfolgen:

Im Inneren eines kristallinen Halbleiters wie Silizium existiert eine Bandstruktur. An der Oberfläche des Halbleiters ist diese gestört, weshalb dort z. B. photogenerierte Ladungsträger leichter rekombinieren können. Dieser Verlustmechanismus reduziert insbesondere die Leerlaufspannung, aber auch die Kurzschlussstromdichte von Solarzellen, wodurch der Wirkungsgrad sinkt. Durch ein Aufbringen einer dielektrischen Schicht auf Bereiche einer Solarzelle, die später nicht kontaktiert werden, können diese Rekombinationsverluste reduziert werden. Man spricht in diesem Zusammenhang von einer verbesserten Passivierung der Oberfläche. Die Verbesserung der Passivierung kann auf mehrere Arten zustande kommen:

Einerseits kann durch das Auftreten von positiven oder negativen Ladungen an der Oberfläche durch die coulombsche Abstoßung von geladenen Teilchen eine Art von Ladungsträgern, also negativ geladene Elektronen oder positiv geladene Defektelektronen, auch Löcher genannt, an der Oberfläche verarmt werden. Da die Rekombination vom Produkt der Ladungsträgerdichten abhängt, kann dadurch bei geeigneter Wahl der Ladungsträgerart, also positive oder negative Ladungen, und Menge der aufgebrachten Ladungsträger die Rekombinationsrate reduziert werden. Andererseits findet die Rekombination an Oberflächendefekten wie offenen Bindungen statt. Eine Reduktion dieser so genannten Grenzflächenzustandsdichte durch chemische Bindungen mit einer aufgebrachten, dielektrischen Schicht ist wichtig, um höhere Wirkungsgrade zu ermöglichen.

In der Regel beruht eine Passivierung auf einer Kombination dieser beiden Effekte. Eine weitere Möglichkeit, die Rekombinationsverluste an der Oberfläche eines Halbleiters zu verringern, ist das Einbringen einer Bandverbiegung im Halbleiter durch eine Eindiffusion eines Dotieratoms. Dazu werden in der Regel Atome aus der dritten oder fünften Hauptgruppe eingesetzt. Im Falle von Silizium als Halbleitermaterial sind das hauptsächlich Phosphor, Bor und Aluminium. Diese wirken ähnlich wie aufgebrachte Ladungen und schirmen die Oberfläche von einer Art von Ladungsträgern ab.

Auf der Vorderseite einer Halbleiterscheibe wie beispielsweise einem Siliziumwafer wird gegenwärtig bei den meisten waferbasierten Solarzellenfertigungslinien eine dielektrische Schicht aus z. B. Siliziumnitrid aufgebracht. Dies kann z. B. durch plasmaunterstützte chemische Gasphasenabscheidung (PECVD) oder durch Kathodenzerstäubung erreicht werden. Die dielektrische Schicht dient dabei der Passivierung der Oberfläche, bildet aber auch eine optisch besonders günstige Anpassung an das Sonnenspektrum aus, um Reflexionsverluste durch die unterschiedlichen Brechungsindizes von Silizium und dem umgebenden Material, z. B. Luft oder polymerbasierten Einkapselungsfolie oder Modulglas, zu verringern.

Auf der Rückseite von Siliziumsolarzellen werden zur Zeit in der industriellen Herstellung keine dielektrischen Schichten verwendet, da die Kontaktierung in der Regel vollflächig mit Hilfe von gedruckten und z. T. getrockneten Pasten und einem anschließenden Hochtemperaturschritt zur Kontaktbildung vonstatten geht. Eine dielektrische Passivierung mit einer nur lokal kontaktierten Rückseite ermöglicht eine deutliche Erhöhung des Wirkungsgrades der Solarzelle, ist aber technologisch anspruchsvoller und wird daher aufgrund der höheren Kosten in der industriellen Fertigung derzeit nicht angewandt.

Weiterhin ist zur Erzielung hoher Wirkungsgrade eine Optimierung hinsichtlich folgender Verlustmechanismen notwendig:

So ist zur Ausbildung eines niedrigen elektrischen Kontaktwiderstandes zwischen Metallisierung und kontaktiertem Halbleiterbereich eine hohe Dotierung vorteilhaft. Andererseits führt eine höhere Dotierung grundsätzlich zu einer höheren Rekombination von Elektron-Lochpaaren innerhalb des Halbleitersubstrates.

Es ist daher sowohl im Emitter- als auch im Basisbereich bekannt, selektive Dotierstrukturen auszubilden.

So ist beispielsweise die Ausbildung selektiver Emitterstrukturen bekannt, in dem beispielsweise auf der dem Licht zugewandten Vorderseite des Halbleitersubstrates flächig ein Emitter mit einem ersten Dotierprofil ausgebildet wird und lediglich in den Bereichen, in denen eine Kontaktierung des Emitters durch eine auf die Vorderseite der Halbleiterstruktur aufgebrachte metallische Emitterkontaktstruktur ausgebildet werden soll, wird ein zweites Emitterprofil mit einer gegenüber dem ersten Profil höheren Querleitfähigkeit und höheren Oberflächendotierung ausgebildet. Durch solch einen selektiven Emitter ist gewährleistet, dass bei Querleitung der Ladungsträger innerhalb des Emitterbereiches des ersten Emitterprofils eine Verringerung der Rekombination erzielt wird und andererseits aufgrund der höheren Dotierung, insbesondere der höheren Oberflächenkonzentration des zweiten Dotierprofils, ein geringer Kontaktwiderstand zu der metallischen Kontaktstruktur erzielt wird.

Im Ergebnis liegen somit an den Oberflächen eines Halbleitersubstrates zur Herstellung einer Solarzelle typischerweise sowohl p- als auch n-dotierte Bereiche vor sowie jeweils hochdotierte und niederdotierte Bereiche des jeweiligen Dotierungstyps, d. h. Bereiche mit hoher und demgegenüber niedrigerer Oberflächendotierkonzentration.

Ein Verfahren zur Herstellung einer Solarzelle mit selektiver Dotierstruktur an der Vorderseite eines Silizium-Substrats ist aus US 2009/0020158 A1 bekannt. Bei diesem Verfahren wird die Oberfläche des Substrats dadurch passiviert, dass nach Erzeugen der selektiven Dotierstruktur eine Siliziumoxidschicht mittels thermischer Oxidation an der Oberfläche bereitgestellt wird.

Der vorliegenden Erfindung liegt daher die Aufgabe zugrunde, ein Verfahren zur Herstellung einer photovoltaischen Solarzelle zu schaffen, bei dem eine Wirkungsgradsteigerung dadurch erzielt wird, dass Vorder- und Rückseite eines Halbleitersubstrates zur Herstellung einer Solarzelle zumindest bereichsweise hinsichtlich der Oberflächenrekombinationsgeschwindigkeit passiviert werden und die Passivierung sowohl auf Bereichen mit p-Dotierung als auch mit n-Dotierung an der Oberfläche wirksam ist. Weiterhin soll das erfindungsgemäße Verfahren industriell kostengünstig implementierbar sein, insbesondere verglichen mit vorbekannten Verfahren zur bereichsweisen Passivierung der Oberflächen eines Halbleitersubstrates.

Gelöst ist diese Aufgabe durch ein Verfahren zur Herstellung einer photovoltaischen Solarzelle gemäß Anspruch 1. Vorzugsweise Ausführungsformen des erfindungsgemäßen Verfahrens finden sich in den Ansprüchen 2 bis 14.

Das erfindungsgemäße Verfahren umfasst folgende Verfahrensschritte:

In einem Verfahrensschritt A erfolgt ein Texturieren einer Vorderseite eines Silizium-Halbleitersubstrates, welches mit einem Basisdotierungstyp dotiert ist. Die Texturierung bewirkt einen verstärkten Lichteinfang der Oberfläche. Beispielsweise können alkalische oder saure Ätzlösungen oder Plasma-basierte Prozesse zur Oberflächentexturierung verwendet werden.

In einem Verfahrensschritt B erfolgt das Erzeugen mindestens einer selektiven Dotierstruktur an der Vorderseite des Halbleitersubstrates, wobei an der Vorderseite mindestens ein flächiger Niedrigdotierbereich mit einem ersten Dotierprofil in dem Halbleitersubstrat erzeugt wird und weiterhin innerhalb des ersten Niedrigdotierbereiches mindestens ein lokaler Hochdotierbereich eines zweiten Dotierprofils erzeugt wird. Der Niedrigdotierbereich und der Hochdotierbereich werden jeweils mit einer Dotierung eines Emitterdotierungstyps ausgebildet, wobei der Emitterdotierungstyp entgegengesetzt zu dem Basisdotierungstyp ist. Dotierungstypen sind hierbei die n-Dotierung und die hierzu entgegengesetzte p-Dotierung.

Der Hochdotierbereich wird in Verfahrenschritt B mit einem niedrigerem Querleitungswiderstand ausgebildet als der Niedrigdotierbereich.

In einem Verfahrensschritt C erfolgt ein Aufbringen mindestens einer metallischen Emitterkontaktstruktur auf der Vorderseite des Halbleitersubstrates, gegebenenfalls auf weitere Zwischenschichten. Das Aufbringen erfolgt zumindest teilweise an den Bereichen lokaler Hochdotierung, wobei die Emitterkontaktstruktur elektrisch leitend mit dem Hochdotierbereich verbunden wird. Weiterhin erfolgt in Verfahrensschritt C ein Aufbringen mindestens einer metallischen Basiskontaktstruktur auf der Rückseite des Halbleitersubstrates, gegebenenfalls auf weiteren Zwischenschichten, wobei die Basiskontaktstruktur mit einem Bereich des Halbleitersubstrates mit einer Dotierung des Basisdotierungstyps elektrisch leitend verbunden wird.

Diese vorgenannten Verfahrensschritte sind aus dem Stand der Technik zur Herstellung einer photovoltaischen Solarzelle mit einer selektiven Dotierstruktur und texturierter Vorderseite bekannt.

Wesentlich ist, dass bei dem erfindungsgemäßen Verfahren zwischen den Verfahrensschritten B und C, gegebenenfalls unter Zwischenschaltung weiterer Zwischenschritte, in einem Verfahrensschritt B1 auf Vorder- und Rückseite des Halbleitersubstrates gleichzeitig jeweils eine Siliziumoxidschicht mittels thermischer Oxidation erzeugt wird, wobei die Siliziumoxidschichten in den auf Verfahrensschritt B1 nachfolgenden Verfahrensschritten nicht wieder entfernt werden, und dass zwischen Verfahrensschritt B und Verfahrensschritt B1 eine oberflächennahe Schicht mindestens auf der Vorderseite des Substrats entfernt wird.

Die auf der Vorderseite erzeugte Vorderseitensiliziumoxidschicht wird hierbei mit einer Dicke kleiner als 150 nm erzeugt.

Die zugrunde liegende Aufgabe wird somit bei dem erfindungsgemäßen Verfahren durch Verwendung einer beidseitig, auf Vorder- und Rückseite in Verfahrenschritt B1 aufgebrachten thermischen gewachsenen Oxidschicht gelöst.

Da das thermische Oxid in den Halbleiter "hinein wächst", d. h. eine Siliziumschicht mit geringer Dicke jeweils an Vorder- und Rückseite des Halbleitersubstrates in eine Oxidschicht umgewandelt wird und damit die Grenzfläche zwischen Halbleiter und thermischem Oxid wandert, zeichnet sich das thermische Oxid durch eine äußerst geringe Dichte an Grenzflächenzuständen an der Grenzfläche zu dem Halbleitersubstrat aus (typischerweise kleiner 10¹¹ cm⁻²eV⁻¹) und entsprechend liegt eine geringe Ladungsdichte (typischerweise kleiner 10¹² cm⁻²) vor. Daher können sowohl p- als auch n-dotierte Bereiche effektiv hinsichtlich der Oberflächenrekombinationsgeschwindigkeit passiviert werden.

Weiterhin wächst das thermische Oxid im Gegensatz zu den sonst üblichen einseitigen Beschichtungsprozessen von allen Oberflächen des Halbleitersubstrates aufgrund der Erzeugung aus der Gasatmosphäre in das Halbleitermaterial hinein. Hierdurch wird somit die simultane Passivierung sowohl der Vorder- als auch der Rückseite des Halbleitersubstrates gelöst.

Weiterhin wird in Verfahrensschritt B1 des erfindungsgemäßen Verfahrens zumindest die Vorderseitensiliziumoxidschicht mit einer Dicke kleiner 150 nm erzeugt. Hierdurch ist gewährleistet, dass einerseits durch die Siliziumoxidschicht eine elektrische Passivierung und damit eine geringere Oberflächenrekombinationsgeschwindigkeit an der Vorderseite, insbesondere sowohl in den hoch als auch in den niedrig dotierten Bereichen der selektiven Emitterstruktur erzielt wird.

Mit dem erfindungsgemäßen Verfahren ist somit in kostengünstiger Weise eine an der Vorderseite texturierte photovoltaische Solarzelle herstellbar, welche in einfacher Weise ohne Verwendung von Maskierungsschritten auf Vorder- und Rückseite passiviert wird, unabhängig von der Dotierung der an diese Oberflächen grenzenden Bereiche und zusätzlich weiterhin die an sich übliche und hinsichtlich der Lichteinkopplung an der Vorderseite vorteilhafte Weiterbildung, beispielsweise mittels einer auf der Vorderseite aufgebrachten Siliziumnitridschicht oder Aluminiumoxidschicht zur Verwendung der Solarzelle in einem glasverkapselten Modul möglich ist. Auch ist die Verwendung von Schichten aus Siliziumkarbid, amorphem Silizium, Siliziumoxid, Siliziumoxinitrid oder Schichtsysteme aus mehreren der genannten Schichten oder anderen dielektrischen Schichten möglich.

Wie zuvor ausgeführt, wird bei dem erfindungsgemäßen Verfahren in einfacher Weise eine Passivierung sowohl von p- als auch von n-dotierten Bereichen an Vorder- und Rückseite des Halbleitersubstrates durch das beidseitige Aufbringen jeweils einer Siliziumoxidschicht erzielt. Vorzugsweise ist das erfindungsgemäße Verfahren daher derart ausgebildet, dass zusätzlich zu dem Erzeugen einer selektiven Emitterdotierstruktur in Verfahrensschritt B weiterhin, an der Rückseite des Halbleitersubstrates eine selektive Dotierstruktur eines Basisdotierungstyps ausgebildet wird, in dem zumindest eine Mehrzahl von Hochdotierbereichen des Basisdotierungstyps an der Rückseite erzeugt werden, auch "lokal back surface field" genannt. Diese Hochdotierbereiche der Rückseite weisen somit eine höhere Dotierkonzentration gegenüber der Basisdotierkonzentration, jedoch den gleichen Dotiertyp auf. Weiterhin ist es vorteilhaft, an der Rückseite einen Niedrigdotierbereich des Basisdotierungstyps auszubilden, der die Rückseite flächig bedeckt und höher dotiert ist, als die Basisdotierung des Halbleitersubstrates, jedoch niedriger dotiert ist, als die Hochdotierungsbereiche. Der Niedrigdotierbereich an der Rückseite des Halbleitersubstrates weist in dieser vorzugsweisen Ausführungsform eine Vielzahl von Hochdotierbereichen des Basisdotierungstyps auf.

Ein thermisches Oxid bildet sich, wenn das Halbleitersubstrat hohen Temperaturen, vorzugsweise Temperaturen oberhalb von 650 °C und einer oxidierenden Atmosphäre ausgesetzt wird. Diese Atmosphäre besteht vorzugsweise aus Wasserdampf, Sauerstoffgas, Ozon oder einer Kombination von diesen. Vorteilhaft ist die Beimischung chlorhaltiger Chemikalien. Ebenso liegt die Beimischung weiterer Gase, wie beispielsweise von Stickstoff oder anderen Inertgasen zum Verdünnen der Gasatmosphäre im Rahmen der Erfindung. Weiterhin kann das thermische Oxid unter erhöhtem Druck (größer 1 Bar) erzeugt werden, um die für die gewünschte Dicke notwendige Oxidationszeit herabzusetzen. Denn die Oxidationsrate nimmt mit höherem Druck zu.

In Verfahrensschritt B1 wird gleichzeitig auf Vorder- und Rückseite des Halbleitersubstrates jeweils eine Siliziumoxidschicht mittels thermischer Oxidation erzeugt. Die Geschwindigkeit, mit der bei thermischer Oxidation eine Siliziumoxidschicht entsteht, d. h. die Aufwachsrate, hängt wesentlich von der Beschaffenheit der Oberfläche und der Oberflächendotierkonzentration des Halbleitersubstrates an der Oberfläche ab. Die Aufwachsrate ist an texturierten Oberflächen im Allgemeinen höher als auf ebenen Flächen, insbesondere bei monokristallinen Silizium-Halbleitersubstraten, die eine Zufallspyramiden-Struktur aufweisen, wobei die Flächen der Pyramiden die Kristallorientierung (111) aufweisen. Ebenso ist die Aufwachsrate bei höherer Oberflächendotierdotierkonzentration größer als bei niedriger Oberflächendotierkonzentration.

Im Allgemeinen würde daher bei üblichen thermischen Oxidationsprozessen die Siliziumoxidschicht in Verfahrenschritt B1 auf der Vorderseite mit einer wesentlich größeren Aufwachsrate entstehen, als auf der Rückseite des Halbleitersubstrates.

Vorzugsweise ist das erfindungsgemäße Verfahren derart ausgebildet, dass in Verfahrensschritt B1 die Siliziumoxidschicht auf der Rückseite mit einer Dicke aufgebracht wird, die um weniger als 10 nm, bevorzugt weniger als 5 nm, insbesondere weniger als 2 nm von der Dicke der Siliziumschicht auf der Vorderseite abweicht. Hierdurch ist gewährleistet, dass bei Erzielung einer für die Passivierung vorteilhaften Mindestdicke der Siliziumoxidschicht auf der Rückseite, vorzugsweise zwischen 5 nm und 30 nm, dennoch keine erheblich dickere Siliziumoxidschicht auf der Vorderseite entsteht und somit einerseits eine ausreichende elektrische Passivierung auf der Rückseite und andererseits eine vernachlässigbar geringe Beeinträchtigung der optischen Eigenschaften der Vorderseite aufgrund der geringen Dicke der Vorderseitensiliziumoxidschicht erreicht wird.

In einer weiteren vorteilhaften Ausführungsform wird die vorderseitige Oxidschicht mit einer Dicke erzeugt, die die Lichteinkopplung für den Fall, dass keine weiteren Schichten aufgebracht werden, maximiert. Hierzu sind Schichtdicken im Bereich von 80 nm bis 120 nm, insbesondere von etwa 100 nm vorteilhaft. Die Schichtdicke der rückseitigen Siliziumoxidschicht beträgt in diesem Fall vorzugsweise 10 nm bis 120 nm, bevorzugt 20 nm bis 105 nm, im weiteren bevorzugt 50 nm bis 105 nm.

Typischerweise wird ein Solarzelle jedoch derart verwendet, dass mehrere Solarzellen in einem Modul verkapselt werden. Hierzu ist es vorteilhaft, dass bei dem erfindungsgemäßen Verfahren in Verfahrensschritt B1 die auf der Vorderseite erzeugte Vorderseitensiliziumoxidschicht mit einer Dicker kleiner 30 nm erzeugt wird. Hierdurch wird einerseits eine ausreichende elektrische Passivierung erzielt, andererseits ist die optische Eigenschaft hinsichtlich der Einkopplung elektromagnetischer Strahlung an der Vorderseite der Halbleiterstruktur aufgrund der Dicke der Vorderseitensiliziumoxidschicht kleiner 30 nm nicht abschließend bestimmt. Insbesondere kann beispielsweise eine an sich übliche Siliziumnitridschicht auf die Siliziumoxidschicht aufgebracht werden, so dass sich insbesondere bei der typischen Verwendung der Solarzelle im Modul ein die optischen Eigenschaften nur wenig beeinträchtigender Brechungsindexverlauf ausgehend von dem Halbleitersubstrat, welches vorzugsweise aus Silizium ausgebildet ist, über die Siliziumoxidschicht, die Siliziumnitridschicht und schließlich die dem Licht zugewandten Schichten des Moduls.

Wie zuvor erwähnt, wächst das thermische Oxid im Gegensatz zu den sonst üblichen einseitigen Beschichtungsprozessen von allen Oberflächen des Halbleitersubstrates in das Halbleitersubstrat hinein. Zusätzlich zu der elektrischen Passivierung mittels des thermischen Oxids ergibt sich daher ein vorteilhafter Effekt hinsichtlich der in Verfahrensschritt B an der Vorderseite erzeugten selektiven Emitterstruktur:

Die Emitterstruktur weist ausgehend von der Oberfläche des Halbleitersubstrates abfallende Dotierprofile auf, die Dotierkonzentration nimmt also ausgehend von der Vorderseite des Halbleitersubstrates in Richtung Rückseite des Halbleitersubstrates hin ab. Durch die bei der thermischen Oxidation verwendeten Temperaturen verändert sich das Dotierprofil des Emitters, indem durch den vorhandenen Konzentrationsgradienten des Dotierstoffs die Oberflächenkonzentration abgesenkt wird und der Dotierstoff von der Oberfläche weg in das Innere des Halbleiters diffundiert. Weiterhin wird dadurch, dass das thermische Oxid in das Halbleitersubstrat hineinwächst, somit an der Oberfläche eine Schicht des Halbleitersubstrates in Siliziumoxid umgewandelt. Diese umgewandelte Schicht ist somit elektrisch inaktiv, so dass für die elektrischen Eigenschaften der Solarzelle und insbesondere die Oberflächenrekombinationseigenschaften die Grenzfläche Halbleitersubstrat/Siliziumoxid relevant ist. Die für die elektrischen Eigenschaften relevante Oberflächendotierkonzentration verringert sich daher dadurch, dass einerseits während der thermischen Oxidation durch die Diffusion des Dotierstoffs von der Grenzfläche weg die Oberflächenkonzentration gesenkt wird und zusätzlich das thermische Oxid in das Halbleitersubstrat hineinwächst und dabei eine besonders niedrige Dichte an Grenzflächenzuständen entsteht.

Die niedrigere (elektrisch relevante) Oberflächendotierkonzentration führt somit zu einer Reduktion der Rekombinationsverluste, da insbesondere die Auger-Rekombination mit steigender Dotierkonzentration zunimmt. Durch die thermische Oxidation können auch oberflächennah vorhandene Silicium-Phosphor-Präzipitate (im Falle der Phosphordotierung), welche stark rekombinationsaktiv sind, aufgelöst werden.

Vorzugsweise wird die Vorderseitenoxidschicht in Verfahrensschritt B1 daher derart erzeugt, dass die Oberflächendotierkonzentration des Niedrigdotierbereiches an der Vorderseite weniger als 4x10²⁰ cm⁻³ bevorzugt weniger als 2x10²⁰ cm⁻³, insbesondere weniger als 1x10²⁰cm⁻³, weiter bevorzugt weniger als 5x10¹⁹cm⁻³ beträgt, um Rekombinationsverluste im Niedrigdotierbereich zu verringern.

Um für typische Emitterdotierprofile eine ausreichende Verringerung der Oberflächendotierkonzentration im Niedrigdotierbereich zu erzielen, wird vorzugsweise in Verfahrenschritt B1 an der Vorderseite des Halbleitersubstrates eine Schicht mit einer Dicke im Bereich 2 nm bis 100 nm, bevorzugt im Bereich 2 nm bis 10 nm in Siliziumoxid umgewandelt.

Wie zuvor erwähnt, ist es vorteilhaft, dass die Schichtdicken der in Verfahrensschritt B1 erzeugten Siliziumoxidschichten an Vorder- und Rückseite nicht oder nur geringfügig hinsichtlich der Dicke voneinander abweichen. Untersuchungen des Anmelders haben ergeben, dass vorzugsweise in Verfahrensschritt B1 die Siliziumoxidschichten an Vorder- und Rückseite für eine erste vorgegebene Zeitdauer mit einer ersten Wachstumsrate und für eine folgende zweite vorgegebene Zeitdauer mit einer zweiten, gegenüber der ersten größeren Wachstumsrate erzeugt werden. Dies ist in der Erkenntnis des Anmelders begründet, dass für typische Solarzellen das schnellere Wachstum der Siliziumoxidschicht an der Vorderseite maßgeblich durch die an der Vorderseite vorliegende höhere Oberflächendotierkonzentration aufgrund der an der Vorderseite erzeugten selektiven Emitterstruktur verursacht ist, wie z.B. in Massoud et al., Thermal Oxidation of Silicon in Dry Oxygen Growth-Rate Enhancement in the Thin Regime.

In J. Electrochem. Soc.: SOLID-STATE SCIENCE AND TECHNOLOGY, Vol. 132, No. 11, 1985, 2685-2700. beschrieben.

Weiterhin ist nach Erkenntnis des Anmelders bei geringen Wachstumsraten die Dickendifferenz der erzeugten Siliziumoxidschichen an Vorder- und Rückseite geringer als bei höheren Wachstumsraten. Vorzugsweise erfolgt daher zunächst mit einer ersten, geringen Wachstumsrate ein Aufwachsen der Siliziumoxidschichten unmittelbar auf das Halbleitersubstrat an Vorder- und Rückseite. Sobald die Vorderseite mit einer ersten, dünnen Siliziumoxidschicht bedeckt ist, kann die Wachstumsgeschwindigkeit gesteigert, werden, da nun die Oberflächendotierkonzentration an der Vorderseite des Halbleitersubstrates nicht mehr oder nur noch in geringem Umfang eine Wachstumsbeschleunigung verursacht.

In dieser vorzugsweisen Ausführungsform des erfindungsgemäßen Verfahrens wird somit durch die erste geringe Wachstumsrate eine geringe Dickendifferenz gewährleistet und durch die zweite, gegenüber der ersten höheren Wachstumsrate wird eine Prozessbeschleunigung erzielt, um in einer kürzeren Prozesszeit die gewünschte Gesamtdicke der Siliziumoxidschichten an Vorder- und Rückseite zu erzielen.

Vorzugsweise erfolgt daher das Aufwachsen der Siliziumoxidschichten vorzugsweise mit der ersten geringen Wachstumsrate bis zur Erzeugung einer Siliziumoxidschicht an der Vorderseite mit einer Dicke kleiner 5 nm, vorzugsweise kleiner 4 nm, bevorzugt etwa 3 nm und anschließend erfolgt das Aufbringen der Siliziumoxidschichten mit einer gegenüber der ersten Wachstumsrate größeren Wachstumsrate.

Untersuchungen des Anmelders haben ergeben, dass vorzugsweise in Verfahrensschritt B1 die Wachstumsrate bei Erzeugen der Siliziumoxidschichten an Vorder- und Rückseite derart beeinflusst wird, dass für eine erste vorgegebene Zeitdauer die thermische Oxidation in einer Gasatmosphäre mit weniger als 10 % Sauerstoffgasanteil erfolgt und anschließend der Sauerstoffgasanteil erhöht wird. Insbesondere ist die Verringerung des Sauerstoffgasanteils durch Zuleitung von Inertgasen, vorzugsweise Stickstoff, prozessual unaufwändig durchführbar. Durch die Variation des Sauerstoffgasanteils kann somit in einfacher Weise die Wachstumsgeschwindigkeit variiert werden und es kann der Verfahrensschritt B1 einerseits hinsichtlich des Erzeugens von Siliziumoxidschichten an Vorder- und Rückseite mit nur geringer Dickendifferenz und andererseits hinsichtlich einer möglichst kurzen Gesamtprozessdauer optimiert werden. Ebenso liegen andere Atmosphärenzusammensetzungen im Rahmen der Erfindung, beispielsweise mit H₂O-Dampf, insbesondere mit gereinigtem Wasserdampf, der aus verdampften, deionisiertem Wasser erzeugt wird, und die Zugabe von chlorhaltigen Verbindungen. Auch hier ist die Zugabe von Inertgasen zum Verdünnen der Gasatmosphäre vorteilhaft.

Vorzugsweise erfolgt Verfahrensschritt B1 mit folgenden Sauerstoffgaskonzentrationen für folgende Zeiten: Für die erste Zeitdauer mit einer Konzentration kleiner 10 % Sauerstoffgasanteil für weniger als 60 Minuten, vorzugsweise weniger als 30 Minuten, bevorzugt weniger als 10 Minuten und für die zweite Zeitdauer mit einer Konzentration größer 10% Sauerstoffgasanteil für weniger als 60 Minuten, weiter bevorzugt weniger als 10 Minuten, vorzugsweise weniger als 5 Minuten.

Beide Zeitdauern betragen vorzugsweise mindestens 1 Minute weiter bevorzugt mindestens 3 Minuten. Der erste Sauerstoffgasanteil ist vorzugsweise größer als 1 %, weiter bevorzugt größer als 3 %.

Eine besonders einfache Ausführungsform des erfindungsgemäßen Verfahrens ergibt sich in Kombination mit solchen Verfahrensschritten, bei denen in Verfahrensschritt B bei Erzeugen der selektiven Dotierstruktur des Emitterdotierungstyps auf der Vorderseite auch auf der Rückseite zumindest bereichsweise Dotierbereiche des Emitterdotierungstyps entstehen. Solche Dotierverfahren sind besonders kostengünstig realisierbar, da keine einseitige Abscheidung oder kein zusätzlicher Schutz der Rückseite durch eine in zusätzlichen Prozessschritten aufgebrachte Schicht notwendig ist.
Ebenso liegt es im Rahmen der Erfindung, vor Einbringen der Emitterdotierung auf der Rückseite eine Diffusionsbarrierenschicht aufzubringen, so dass an der Rückseite keine Emitterdiffusion erfolgt.

Vorzugsweise wird daher zwischen Verfahrensschritt B und Verfahrensschritt B1 auf der Rückseite des Silizium-Halbleitersubstrates eine Schicht entfernt, welche eine Dotierung des Emitterdotierungstyps aufweist oder eine Diffusionsbarrierenschicht ist. Insbesondere ist es vorteilhaft, dass die Entfernung nasschemisch in an sich bekannter Weise erfolgt. Vorzugsweise wird die Diffusionsbarrierenschicht vollständig entfernt und/oder eine Silizium-Schicht mit einer Dicke von mindestens 0,1 µm, weiter bevorzugt mindestens 0,5 µm, insbesondere mindestens 1 µm, weiter bevorzugt im Bereich von 0,1 µm bis 20 µm entfernt. Vorzugsweise erfolgt die Entfernung ganzflächig an der Rückseite.

Das erfindungsgemäße Verfahren zeichnet sich weiterhin dadurch aus, dass die zur Passivierung verwendeten Siliziumoxidschichten eine elektrische Passivierung bewirken und andererseits aufgrund der geringen Dicke an der Vorderseite die optischen Eigenschaften nicht nachteilig hinsichtlich einer Verwendung der Solarzelle in einem Modul beeinträchtigt werden oder die Oxidschicht als Antireflexschicht verwendet werden kann.

Vorzugsweise werden die Siliziumschichten auf Vorder- und Rückseite in den auf Verfahrensschritt B1 nachfolgenden Verfahrensschritten daher nicht wieder entfernt. Im Gegensatz zu anderen Verfahren, bei denen beispielsweise Oberflächendotierkonzentrationen durch Aufwachsen einer Siliziumoxidschicht und Entfernen dieser Siliziumoxidschicht erzielt werden, stellt das erfindungsgemäße Verfahren einen weniger komplexen Prozessablauf dar und ist somit kostengünstiger.

Vorzugsweise werden bei dem erfindungsgemäßen Verfahren vor Verfahrensschritt B1, bevorzugt zwischen Verfahrensschritt A und Verfahrenschritt B1, insbesondere bevorzugt zwischen Verfahrensschritt B und Verfahrenschritt B1, gegebenenfalls unter Zwischenschaltung weiterer Zwischenschritte, Unebenheiten an der rückseitigen Oberfläche des Halbleitersubstrates eingeebnet oder zumindest verringert. Hierdurch ergibt sich der Vorteil, dass die Passivierungseigenschaften der Siliziumoxidschicht auf der Rückseite des Halbleitersubstrates zusätzlich verbessert werden, da die elektrische Passivierung grundsätzlich auf ebenen Oberflächen eine höhere Güte erzielt als auf texturierten Oberflächen.

Das Einebnen erfolgt vorzugsweise mittels nasschemischer Verfahren unter Verwendung saurer oder alkalischer Ätzlösungen oder mittels Plasma-unterstützter Prozesse, insbesondere vorzugsweise maskierungsfrei in einer Durchlaufanlage. Vorzugsweise wird die Schicht mittels nasschemischen Ätzens entfernt, insbesondere vorzugsweise mittels einer Mischung aus Fluorwasserstoffsäure (HF), Salpetersäure (HNO₃), Essigsäure (CH₃COOH) und Wasser (H₂O). Das Entfernen erfolgt vorzugsweise folgende Verfahrensschritte umfassend: Durch eine Ätzlösung wird Silizium geätzt oder in Schicht von porösem Silizium umgewandelt, welche dann in einem kurzen zweiten Ätzschritt durch in Wasser verdünntes Kaliumhydroxid (KOH) abgenommen wird. Vorzugsweise erfolgt nach einem Ätzschritt, bevorzugt nach jedem Ätzschritt ein Spülen der Oberflächen.

Des Weiteren kann das Einebnen der Rückseite durch Flusssäure (HF) unter Zugabe von Tensiden erfolgen, vorzugsweise unter Verwendung höher konzentrierter Flusssäure.

Des Weiteren kann das Einebnen der Rückseite durch Phosphorsäure (H₃PO₄) erfolgen.

Des Weiteren kann das Einebnen der Rückseite durch Schwefelsäure (H₂SO₄) oder in H₂O verdünnte H₂SO₄ erfolgen.

Des Weiteren kann das Einebnen der Rückseite durch in H₂O gelöstes Kaliumhydroxid (KOH) oder Natriumhydroxid (NaOH) erfolgen.

Des Weiteren kann das Einebnen der Rückseite durch in H₂O gelöstes Natriumhypochlorid (NaOCl) erfolgen.

In einer weiteren vorzugsweisen Ausführungsform des erfindungsgemäßen Verfahrens wird die Einebnung mittels plasmaunterstütztem Ätzen durchgeführt.

Bei einer besonders vorteilhaften Ausführung wird mit dem Einebnen gleichzeitig ein auf der rückseitigen Oberfläche vorhandener, einen dem Substrat entgegengesetzten Dotiertyp aufweisender Dotierbereich entfernt. Dieser Dotierbereich entsteht, wenn in Verfahrensschritt B prozessbedingt sowohl auf der Vorderseite als auch auf der Rückseite des Halbleitersubstrates einen Dotierbereich des Emitterdotierungstyps erzeugt wird.

Bei dem erfindungsgemäßen Verfahren wird des weiteren, wie zuvor beschrieben, zwischen Verfahrensschritt B und Verfahrenschritt B1, gegebenenfalls unter Zwischenschaltung weiterer Zwischenschritte, auf der Vorderseite des Halbleitersubstrates eine oberflächennahe Schicht abgetragen. Hierdurch ergibt sich der bereits beschriebene Vorteil einer verringerten Oberflächenkonzentration im Niedrigdotierbereich des Emitters. Das Entfernen der oberflächennahen Schicht reduziert den Umfang der durch die anschließende thermische Oxidation zu erbringenden Umwandlung der Dotierbereiche auf der Vorderseite, wodurch Prozesszeit eingespart werden kann. Die Dicke dieser Schicht liegt vorzugsweise im Bereich 1 nm bis 300 nm.

Die kontrollierte Entfernung dieser oberflächennahe Schicht kann mittels nasschemischen Ätzen (Alkalische und/oder saure Lösungen), nasschemischer Oxidation (z.B. mittels Lösungen, die Ozon oder Wasserstoffperoxid enthalten) und anschließend nasschemicher Entfernung der Oxidschicht, beispielsweise in Flusssäure oder mittels Plasmaätzen erfolgen.

Das Entfernen der oberflächennahen Schicht kann durch eine, oder mehrere hintereinander ausgeführte nasschemische Reinigungen erfolgen, wie sie beispielsweise in W. Kern, "Handbook of semiconductor wafer cleaning technology". (Noyes, Park Ridge, New Jersey, 1993) beschrieben sind.

Vorzugsweise wird die Schicht mittels nasschemischen Ätzens entfernt, insbesondere vorzugsweise mittels einer Mischung aus Fluorwasserstoffsäure (HF), Salpetersäure (HNO₃), Essigsäure (CH₃COOH) und Wasser (H₂O). Das Entfernen erfolgt vorzugsweise folgende Verfahrensschritte umfassend: Durch eine Ätzlösung wird eine Schicht von porösem Silizium gebildet, welche dann in einem kurzen zweiten Ätzschritt durch in Wasser verdünntes Kaliumhydroxid (KOH) abgenommen wird. Anschließend wird ein Spülen in Wasser (H₂O) vorgenommen.

Des Weiteren kann das Entfernen der oberflächennahen Schicht durch Flusssäure (HF) unter Zugabe von Tensiden erfolgen, vorzugsweise unter Verwendung höher konzentrierter Flusssäure.

Des Weiteren kann das Entfernen der oberflächennahen Schicht durch Phosphorsäure (H₃PO₄) erfolgen.

Des Weiteren kann das Entfernen der oberflächennahen Schicht durch Schwefelsäure (H₂SO₄) oder in H₂O verdünnte H₂SO₄ erfolgen.

Des Weiteren kann das Entfernen der oberflächennahen Schicht durch in H₂O gelöstes Kaliumhydroxid (KOH) oder Natriumhydroxid (NaOH) erfolgen.

Des Weiteren kann das Entfernen der oberflächennahen Schicht durch in H₂O gelöstes Natriumhypochlorid (NaOCl) erfolgen.

In einer weiteren vorzugsweisen Ausführungsform des erfindungsgemäßen Verfahrens wird die Schichtabnahme mittels plasmaunterstütztem Ätzen durchgeführt.

Weiterhin zeigten Untersuchungen des Anmelders, dass mittels des erfindungsgemäßen Verfahrens in folgender vorzugsweisen Ausführungsform in besonderer Weise Solarzellen mit hohen Wirkungsgraden bei gleichzeitiger kostengünstiger und industriell implementierbarer Prozessführung herstellbar sind:

Vorzugsweise wird in Verfahrensschritt B die selektive Emitterdotierstruktur folgende Verfahrensschritte umfassend erzeugt:

In einem Verfahrensschritt Ba wird eine Dotierstoff enthaltende Dotierschicht auf die Vorderseite des Halbleitersubstrates aufgebracht. Vorzugsweise erfolgt dies mittels Gasphasenabscheidung, beispielsweise CVD, APCVD, PECVD, PVD oder durch Aufwachsen von dotierten Silikatgläsern aus der Gasatmosphäre (z.B. Phosphorsilikatglas (PSG) oder Borsilikatglas (BSG)), alternativ mittels Drucken von dotierhaltigen Pasten oder Aufschleudern oder Aufsprühen von Dotierflüssigkeiten (z.B. von verdünnter Phosphorsäure). Auch liegt das Aufbringen durch Kathodenzerstäubung im Rahmen der Erfindung.

In einem Verfahrensschritt Bb erfolgt ein lokales Erhitzen eines Schmelzbereiches der Dotierschicht und eines unterhalb der Dotierschicht liegenden Schmelzbereiches des Halbleitersubstrates, derart, dass sich in einem lokalem Bereich kurzzeitig eine Schmelzmischung aus zumindest dem Schmelzbereich, der Dotierschicht und dem Schmelzbereich des Halbleitersubstrates bildet, wobei Flüssig-Flüssig-Diffusion Dotierstoff aus der Dotierschicht in das aufgeschmolzene Halbleitersubstrat diffundiert, so dass nach Erstarren der Schmelzmischung der Hochdotierungsbereich erzeugt ist.

In einem Verfahrensschritt Bc erfolgt das Erzeugen des flächigen Niedrigdotierbereiches, in dem das Halbleitersubstrat global erwärmt wird, derart, dass Dotierstoff aus der Dotierschicht in das Halbleitersubstrat diffundiert.

In einem Verfahrensschritt Bd wird die Dotierschicht entfernt.

Die vorgenannten Verfahrensschritte Ba bis Bd werden hierbei in der Abfolge Ba, Bb, Bc, Bd oder Ba, Bc, Bb, Bd ausgeführt, jeweils gegebenenfalls unter Zwischenschaltung weiterer Zwischenschritte. Insbesondere werden vorzugsweise die Verfahrensschritte Ba und Bc gleichzeitig durchgeführt.

Falls im Verfahrensschritt Bc prozesstechnisch bedingt auch auf der Rückseite ein Bereich entsteht, der den gleichen Dotierungstyp wie der Emitter aufweist, so wird dieser vorzugsweise entfernt. Vorzugsweise wird dieser rückseitige Dotierungsbereich mit einem Verfahren entfernt, wie zuvor zum Einebnen der Rückseite beschrieben.

Vorzugsweise erfolgt anschließend eine nasschemische oder plasmabasierte Reinigung des Halbleitersubstrats.

Anschließend wird, wie zuvor beschrieben, in Verfahrenschritt B1 die Siliziumoxidschicht mittels thermischer Oxidation auf Vorder- und Rückseite erzeugt, wobei unter anderem, wie zuvor beschrieben, insbesondere an der Vorderseite eine oberflächennahe Schicht des Halbleitersubstrates in eine elektrisch inaktive Siliziumoxidschicht umgewandelt wird.

In dieser vorzugsweisen Ausführungsform wird in kostengünstiger, industriell implementierbarer Weise eine selektive Emitterdotierstruktur erzielt. Einerseits wird durch die Dotierschicht, welche in Verfahrensschritt Bc durch globale Erwärmung des Halbleitersubstrates den flächigen Emitterbereich niedriger Dotierung erzeugt und in Verfahrensschritt Bb durch lokales Erhitzen den oder die Hochdotierungsbereiche erzeugt, in einfacher Weise ein selektives Dotierprofil erstellt, ohne dass hierfür kostenintensive Maskierungsschritte notwendig wären. Dies ist insbesondere darin begründet, dass in Verfahrensschritt Bc die thermische Diffusion aus der Dotierschicht in das Halbleitersubstrat wesentlich langsamer erfolgt, verglichen mit der lokalen Flüssig-Flüssig-Diffusion in den temporär aufgeschmolzenen lokalen Bereichen in Verfahrenschritt Bb. Bereits durch die unterschiedlichen Diffusionsmechanismen ist gewährleistet, dass in Verfahrensschritt Bc ein Dotierbereich mit niedrigerer Dotierung erzeugt wird, verglichen mit den in Verfahrensschritt Bb erzeugten Dotierbereichen.

Sofern in Verfahrensschritt Bc prozessbedingt ein Dotierbereich des Emitterdotierungstyps an der Rückseite des Halbleitersubstrates entsteht, wird vorzugsweise nach Verfahrensschritt Bc und vor Verfahrensschritt B1 eine Halbleiterschicht an der Rückseite des Halbleitersubstrates entfernt, so dass der rückseitige Dotierbereich des Emitterdotierungstyps entfernt wird.

Wie zuvor beschrieben wird erfindungsgemäß zwischen Verfahrenschritt Bd und B1, gegebenenfalls unter Zwischenschaltung weiterer Zwischenschritte, eine oberflächennahe Schicht abgetragen, bevorzugt durch eine nasschemische Reinigung des Halbleitersubstrats, die gleichzeitig metallische, organische oder weitere Verunreinigungen entfernt.

Die in den nachfolgenden Verfahrensschritt B1 erzielte Absenkung der Dotierstoffkonzentration an der Substratoberfläche und die Umwandlung einer oberflächennahen Schicht an der Vorderseite des Halbleitersubstrates in eine elektrisch nicht aktive Siliziumoxidschicht ist insbesondere in der vorzugsweisen Ausführungsform mit Erzeugen der selektiven Emitterstruktur wie zuvor dargestellt, vorteilhaft:

In Verfahrensschritt Bc entstehen typischerweise so genannte "kink and tail" Dotierprofile, d. h. Dotierprofile, die in einem oberflächennahen Bereich eine sehr hohe Dotierkonzentration aufweisen, anschließend einen starken Abfall und schließlich einen flacheren Verlauf. Dies ist an sich bekannt und beispielsweise in Bentzen, A. et al. High concentration in-diffusion of phosphorus in Si from a spray-on source, Journal of Applied Physics, 99 (2006) p. 064502-1-8 beschrieben. Dies ist gültig für Phosphordiffusionen aus einer unerschöpflichen Quelle.

Bei der Flüssig-Flüssig-Diffusion in Verfahrensschritt Bb entsteht hingegen ein Dotierprofil, dass annähernd einem Gaußschen Dotierprofil entspricht, d. h. ausgehend von der Oberfläche fällt die Dotierkonzentration stetig, jedoch wesentlich langsamer, verglichen mit einem kink and tail-Profil ab.

Wird nun in Verfahrensschritt B1 an der Oberfläche der Dotierseite des Halbleitersubstrates eine Schicht umgewandelt, so führt dies im Niedrigdotierbereich zu einer erheblichen Senkung der Oberflächenkonzentration des Dotierstoffes (typischerweise von größer gleich 6x10²⁰ cm⁻³ auf kleiner gleich 2x10²⁰ cm⁻³), da der hochdotierte, oberflächennahe Bereich des kink and tail-Profils ganz oder teilweise in eine elektrisch nicht leitende Schicht umgewandelt wird. An dem oder den in Verfahrensschritt Bb erzeugten lokalen Hochdotierungsbereichen liegt hingegen, wie zuvor erwähnt, zumindest näherungsweise ein Gaußsches Dotierprofil vor, d. h. das Umwandeln der Schicht in Verfahrensschritt B1 führt nur zu einer vergleichsweise geringen Verringerung der Oberflächendotierkonzentration.

Wird erfindungsgemäß wie zuvor beschrieben zusätzlich vor Verfahrensschritt B1 an der Oberfläche der Dotierseite des Halbleitersubstrates eine Schicht entfernt, so führt dies im Niedrigdotierbereich zu einer weiteren erheblichen Senkung der Oberflächenkonzentration des Dotierstoffes, wie zuvor erläutert. Ebenso liegt an dem oder den in Verfahrensschritt B erzeugten lokalen Hochdotierungsbereichen hingegen wie zuvor erwähnt, zumindest näherungsweise ein Gaußsches Dotierprofil vor, d. h. das Entfernen der Schicht führt nur zu einer vergleichsweise geringen Verringerung der Oberflächendotierkonzentration.

Im Ergebnis wird somit in den Niedrigdotierbereichen die Oberflächendotierkonzentration in Verfahrensschritt B1 erheblich gesenkt, so dass in diesen Bereichen die Rekombinationsaktivität, insbesondere aufgrund von Auger-Rekombination und Phosphor-Präzipitaten erheblich gesenkt und damit Wirkungsgradverluste vermieden werden, dies ist beschrieben in Nguyen, V. et al., Analysis of Screen-Printed Silicon Solar Cell Emitters in Proceedings 24th EU PVSEC, Hamburg, 2009. In den Hochdotierbereichen erfolgt hingegen keine oder nur eine vernachlässigbar geringe Absenkung der Oberflächendotierkonzentration in Verfahrensschritt B1, so dass, nach wie vor, ein geringer Kontaktwiderstand zwischen Halbleitersubstrat und metallischer Kontaktstruktur aufgrund der hohen Oberflächendotierkonzentration gewährleistet ist.

In dieser vorzugsweisen Ausführungsform greifen somit mehrere Synergieeffekte und ist in optimierter Weise eine selektive Emitterdotierstruktur herstellbar, die einerseits kostengünstig in industrielle Fertigungsprozesse eingebunden werden kann, insbesondere aufgrund der Reduzierung oder Vermeidung von Maskierungsschritten und andererseits aufgrund der zwar prozessual einfachen und dennoch effektiven Passivierung der Oberflächen an Vorder- und Rückseite durch die Siliziumoxidschichten ein hoher Gesamtwirkungsgrad der fertigen Solarzelle erzielt wird.

In einer vorteilhaften Ausgestaltung des erfindungsgemäßen Verfahrens erfolgt die Ausführung der Verfahrensschritte Ba bis Bd ohne Zwischenschaltung von Maskierungsschritten, um Kosten einzusparen.

Dies unterscheidet weiterhin das erfindungsgemäße Verfahren von vorbekannten Verfahren zur Erzeugung selektiver Emitterdotierstrukturen, in denen mehrere kostenintensive Maskierungsschritte notwendig sind.

Das lokale Erhitzen in Verfahrensschritt Bb erfolgt vorzugsweise mittels eines Lasers. Hierbei kann auf an sich bekannte Verfahren zur Laserdotierung zurückgegriffen werden, wie beispielsweise in Jäger, U., et al. Selective emitter by laser doping from phosphosilicate glass. in Proceedings of the 24th European Photovoltaic Solar Energy Conference. 2009. Hamburg, Germany beschrieben.

Die in Verfahrensschritt Ba aufgebrachte Dotierschicht weist vorzugsweise eine Dicke zwischen 10 nm und 1 µm, bevorzugt zwischen 10 nm und 500 nm, im weiteren bevorzugt zwischen 10 nm und 100 nm auf. Hierdurch ist gewährleistet, dass ausreichend Dotierstoff für die nachfolgenden Dotierprozesse vorliegt.

Weiterhin ist es vorteilhaft, dass die Dotierschicht Dotierstoff in einer Konzentration von mindestens 1 Gewichtsprozent, bevorzugt mindestens 4 Gewichtsprozent, im Weiteren bevorzugt im Bereich von 6 bis 10 Gewichtsprozent aufweist.

In Verfahrensschritt Ba wird die Dotierschicht, vorzugsweise die gesamte Dotierseite des Halbleitersubstrates bedeckend, aufgebracht. Hierdurch ist eine Prozessvereinfachung gegeben.

In Verfahrensschritt Bb erfolgt vorzugsweise eine lokale Erwärmung des Halbleitersubstrates auf mindestens 1410 °C, um ein lokales Aufschmelzen und die vorgenannte Flüssig-Flüssig-Diffusion zu gewährleisten.

Zur Verfahrensvereinfachung und Kostenreduzierung werden vorzugsweise in den Verfahrensschritten Bb und Bc die Dotierbereiche derart erzeugt, dass der Niedrigdotierbereich die Vorderseite des Halbleitersubstrates vollständig bedeckend aufgebracht wird und eine Vielzahl von Hochdotierungsbereichen ausgebildet werden. Insbesondere die Ausbildung des Niedrigdotierbereiches, welche die Vorderseite vollständig bedeckt, ist verfahrenstechnisch einfach durchführbar, insbesondere dadurch, dass in Verfahrensschritt Ba die Dotierschicht die Vorderseite des Halbleitersubstrates vollständig bedeckend aufgebracht wird.

Hoch- und Niedrigdotierbereiche werden in Verfahrensschritt B vorzugsweise parallel zur Vorderseite des Halbleitersubstrates ausgebildet, d. h. sich jeweils die Dotierkonzentration parallel zur Vorderseite im Wesentlichen nicht ändert und das abfallende Emitterdotierprofil senkrecht zur Vorderseite, ausgehend von der Vorderseite, abfallend zur Rückseite hin, ausgebildet ist. Ebenso sind die Siliziumoxidschichten an Vorder- und Rückseite des Halbleitersubstrates vorzugsweise parallel zur Oberfläche ausgebildet.

Das erfindungsgemäße Verfahren eignet sich insbesondere zur Herstellung von Solarzellen, welche im Wesentlichen aus einem Silizium-Halbleitersubstrat ausgebildet sind. Insbesondere ist die Verwendung von mono- oder multikristallinen Siliziumwafern als Halbleitersubstrat vorteilhaft.

An der Vorderseite einer Solarzelle werden typischerweise metallische Kontaktstrukturen mit linienartigen Elementen, vorzugsweise kammartige oder doppelkammartige Metallstrukturen, ausgebildet. Hierdurch ist einerseits ein geringer mittlerer Abstand zwischen einem beliebigem Punkt an der Vorderseite des Halbleitersubstrates und der nächstliegenden Metallstruktur gewährleistet und andererseits wird die durch die Metallstruktur abgedeckte Fläche minimiert, so dass hierdurch entstehende optische Verluste minimiert sind.

Vorzugsweise erfolgt daher in Verfahrensschritt B die Erzeugung der Hochdotierbereiche, welche zur Bedeckung mit einer Metallkontaktstruktur ausgebildet werden, vorzugsweise linienartig, insbesondere vorzugsweise kammartig oder doppelkammartig.

In Verfahrensschritt B werden die Dotierbereiche vorzugsweise derart erzeugt, dass der Niedrigdotierbereich die Vorderseite des Halbleitersubstrates vollständig bedeckt und eine Vielzahl von Hochdotierungsbereichen innerhalb des Niedrigdotierbereiches ausgebildet wird. Dadurch, dass der Niedrigdotierbereich die Vorderseite vollständig bedeckend ausgebildet wird, wird eine weitere Prozessvereinfachung erzielt.

Die vorgenannten Siliziumoxidschichten sind vorteilhafterweise als Siliziumdioxidschichten (SiO₂) ausgebildet.

Weitere Merkmale und bevorzugte Ausführungsformen der Erfindung ergeben sich aus den Figuren und der Figurenbeschreibung. Dabei zeigt:

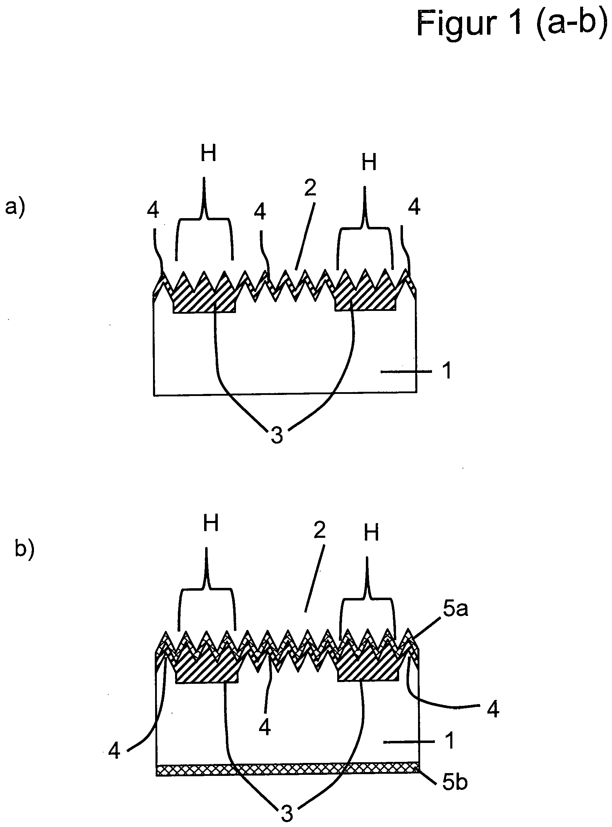

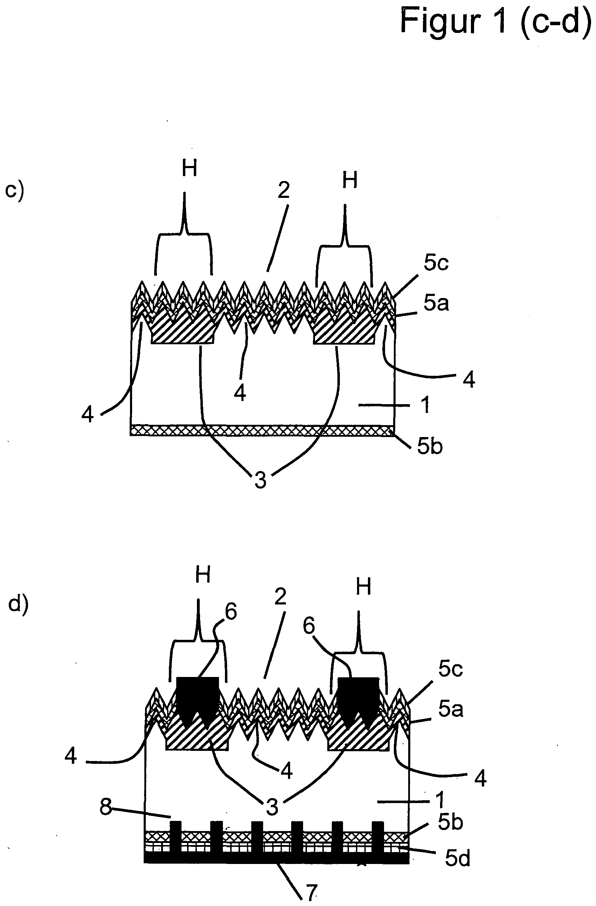

- Figur 1: ein Ausführungsbeispiel des erfindungsgemäßen Verfahrens, bei dem die Hochdotierbereiche mittels lokalem Aufschmelzen durch einen Laser erzeugt werden.

In den Figuren 1a bis d sind jeweils Teilausschnitte eines als Siliziumwafer ausgebildeten Halbleitersubstrat 1 dargestellt. Das Halbleitersubstrat 1 ist p-dotiert mit einer Dotierkonzentration von etwa 10¹⁶ cm⁻³, besitzt eine Dicke von 200 µm und ist etwa quadratisch ausgebildet mit einer Kantenlänge von 15,6 cm.

Gleiche Bezugszeichen in den Figuren 1a bis 1d bezeichnen gleiche Elemente. Weiterhin ist jeweils die zur Lichteinkopplung auszubildende Vorderseite des Halbleitersubstrates in den Figuren 1a bis 1d obenliegend dargestellt.

In einem Verfahrensschritt A erfolgt die Texturierung des Halbleitersubstrates 1. Das Halbleitersubstrat 1 ist als monokristalliner Siliziumwafer ausgebildet und wird zur Texturierung mit einer nasschemischen Lösung (enthaltend Kaliumhydroxid (KOH), Isopropanol (C₃H₈O) und Wasser (H₂O)) behandelt, so dass einerseits eventuell noch vorhandener Sägeschaden, resultierend aus der Waferherstellung beseitigt wird und darüber hinaus an Vorder- und Rückseite aufgrund der unterschiedlichen Ätzgeschwindigkeit, abhängig von der Kristallorientierung eine pyramidenartige Textur (so genannte "random pyramids") entsteht. Der Texturprozess wird dabei im batch-Verfahren durchgeführt.

Die Texturierung führt zu einer erhöhten Lichteinkopplung an der Vorderseite 2, ist jedoch schlechter elektrisch passivierbar, verglichen mit einer ebenen Oberfläche. Daher wird anschließend an der Rückseite die Textur durch einseitige nasschemische Behandlung wieder entfernt. Vorzugsweise wird die Textur mittels nasschemischen Ätzens eingeebnet, insbesondere vorzugsweise mittels einer Mischung aus Fluorwasserstoffsäure (HF), Salpetersäure (HNO₃), Essigsäure (CH₃COOH) und Wasser (H₂O). Das Entfernen erfolgt folgende Verfahrensschritte umfassend: Durch eine Ätzlösung wird eine Schicht Silizium abgeätzt oder in poröses Silizium umgewandelt, welches dann in einem kurzen zweiten Ätzschritt durch in Wasser verdünntes Kaliumhydroxid (KOH) abgenommen wird. Dies geschieht vorzugsweise mit einer Anlage die sicherstellt, dass nur die Rückseite des Substrates mit der Ätzlösung in Berührung kommt. Das Rückätzen kann auch in alkalischen Lösungen vorgenommen werden oder mittels Plasmaätzen.

Anschließend wird in einem Verfahrensschritt B eine selektive Emitterdotierstruktur an der Vorderseite des Halbleitersubstrates ausgebildet. Die Emitterdotierstruktur wird n-dotiert ausgebildet.

Hierbei erfolgt in einem Verfahrensschritt Ba ein Aufbringen einer Dotierschicht auf die oben liegende Vorderseite des Halbleitersubstrates 1, welche bei der herzustellenden Solarzelle zur Lichteinkopplung ausgebildet sein wird.

Die Dotierschicht wird mittels chemischer Gasphasenabscheidung ("Chemical Vapour Deposition", CVD) abgeschieden und besteht aus SiO_{X}:P (Phosphorsilikatglass "PSG") mit dem Dotierstoff Phosphor in einer Konzentration von 4 bis 8 Gewichtsprozent. Die Schicht kann aber auch mit physikalischer Gasphasenabscheidung (PVD-Verfahren) oder Kathodenzerstäubung aufgebracht werden.

Andere Aufbringverfahren wie Aufschleudern, Aufsprühen oder aufdrucken sind ebenfalls möglich.

In einem Verfahrensschritt Bb wird mittels lokaler Erhitzung durch einen Laserstrahl in lokalen Bereichen H jeweils kurzzeitig eine Schmelzmischung aus der Dotierschicht und dem Halbleitersubstrat 1 erzeugt. Innerhalb der Schmelzmischung erfolgt eine Flüssig-Flüssig-Diffusion des Dotierstoffes aus der Dotierschicht in das Halbleitersubstrat 1, so dass nach Erstarren der Schmelzschicht ein Hochdotierbereich 3 in dem Halbleitersubstrat vorliegt, der an der Oberfläche des Halbleitersubstrates 1 eine Dotierkonzentration von etwa 4x10²⁰ cm⁻³ aufweist.

Der Laserdotierprozess wird mit gepulsten Lasern vorgenommen, die eine Wellenlänge in einem Bereich von 190 nm bis 1100 nm haben. Als Pulslängen sind Längen von 1 ps bis 5 µs in Abhängigkeit der gewählten Repetitionsrate möglich. Vorzugsweise wird ein Laser mit einer Wellenlänge von 343, 355, 515 oder 532 nm bei Pulslängen im Bereich von 10-500 ns gewählt. Es ist ebenfalls möglich, den Dotierprozess mit einem Laser im Dauerstrichbetrieb ("cw" = continuous wave) oder einem cw-Laser im moduliertem Betrieb in den genannten Wellenlängen durchzuführen.

In einem Verfahrensschritt Bc erfolgt eine globale Erwärmung des Halbleitersubstrates 1 in einem Durchlaufofen auf eine Temperatur von 850°C Grad für eine Zeitdauer von 30 Minuten. Hierdurch wird eine Diffusion von Dotierstoff aus der Dotierschicht in das Halbleitersubstrat 1 an der Vorderseite des Halbleitersubstrates erzielt, so dass sich ein Niedrigdotierbereich 4 ausbildet. Aufgrund dieses Prozesses weist der Niedrigdotierbereich ein kink and tail-Profil auf, wie beispielsweise in Bentzen, A. et al. High concentration in-diffusion of phosphorus in Si from a spray-on source, Journal of Applied Physics, 99 (2006) p. 064502-1-8 beschrieben, mit einer Oberflächendotierkonzentration von 5x10²⁰ cm⁻³ und einem Schichtwiderstand von 50 Ohm/sq.

Alternativ kann in einem Verfahrensschritt Bc eine globale Erwärmung des Halbleitersubstrates 1 in einem Rohrofen bei einer Temperatur von 800°C Grad für eine Zeitdauer von 40 Minuten erfolgen. Hierdurch wird eine Diffusion von Dotierstoff aus der Dotierschicht in das Halbleitersubstrat 1 an der Vorderseite des Halbleitersubstrates erzielt, so dass sich ein Niedrigdotierbereich 4 ausbildet. Aufgrund dieses Prozesses weist der Niedrigdotierbereich ein kink and tail-Profil auf, wie beispielsweise in C. Bertram, et al. Emitter profile tailoring by gas flux variation in tube furnace POCl3-diffusion and analysis of the phosphosilicate glass. In 24th European Photovoltaic Solar Energy Conference. 2009. Hamburg, Germany. beschrieben., mit einer Oberflächendotierkonzentration von 7x10²⁰ cm⁻³ und einem Schichtwiderstand von 120 Ohm/sq.

Der Schichtwiderstand des in Verfahrensschritt Bb erzeugten Hochdotierbereiches 3 beträgt hingegen 20 Ohm/sq.

In dem vorgenannten Diffusionsprozess wird prozessbedingt auch ein Dotierbereich des Emitterdotierungstyps an der Rückseite des Halbleitersubstrates erzeugt. Daher wird an der Rückseite eine Schicht mit einer Dicke von etwa 1 µm anschließend entfernt.

In einem Verfahrensschritt Bd wird die Dotierschicht durch folgenden nasschemischen Prozess entfernt: Mittels Ätzen der Vorderseite für weniger als 2 min in 10% Flusssäure (HF) in H₂O und anschließendem Spülen in H₂O.

Anschließend erfolgt eine Reinigung des Halbleitersubstrates 1 in einer nasschemischen Reinigungssequenz. Die Reinigungssequenz umfasst Reinigen in einer erwärmten Lösung aus Ammoniumhydroxid (NH₄OH), Wasserstoffperoxid (H₂O₂) und H₂O, gefolgt einer Reinigung mit einer Dauer kleiner 2 Minuten in 1 % HF, dann in einer erwärmten Mischung aus Salzsäure (HCl), H₂O₂ und H₂O, wieder gefolgt von einer Reinigung mit einer Dauer kleiner 2 Minuten in 1% HF. Diese Reinigungssequenz wird auch SC1/SC2 genannt. Hierbei wird oberflächennahes Silizium samt Fremdatomen chemisch oxidiert und anschließend in der Flusssäure Lösung abgenommen. Dabei steigt bereits der Emitterschichtwiderstand des Emitters im flächigen Niedrigdotierbereich 4, während der Emitterschichtwiderstand in den höher dotierten Hochdotierbereichen 3 aufgrund des dort vorliegenden Gaußschen Dotierprofils kaum ändert.

In einem Verfahrensschritt C wird anschließend mittels thermischer Oxidation in einer sauerstoffhaltigen Atmosphäre ein thermisches Oxid mit einer Dicke von etwa 15 nm auf Vorder- und Rückseite des Halbleitersubstrates gleichzeitig erzeugt. Dies erfolgt in einem Rohrofen oder einem Durchlaufofen. Mittels des thermischen Oxids werden die Oberflächen des Halbleitersubstrates 1 passiviert. Aufgrund der globalen Erwärmung des Halbleitersubstrates auf etwa 850 °C für etwa eine Stunde verbessert sich zudem der flächige Emitter im Niedrigdotierbereich 4, da durch das thermische Budget während der thermischen Oxidation die Oberflächenkonzentration an Dotierstoff sinkt, der Emitter eingetrieben wird und damit die Auger-Rekombination reduziert wird und Präzipitate gelöst werden.

Das Ergebnis mit der Siliziumoxidschicht 5a an der Vorderseite und der Siliziumoxidschicht 5b an der Rückseite ist in Figur 1b dargestellt. Anschließend wird auf die Vorderseite eine Siliziumnitridschicht 5c mit einer Dicke von etwa 70 nm aufgetragen, um die optischen Eigenschaften hinsichtlich der Einkopplung auf die Vorderseite 2 auftreffender elektromagnetischer Strahlung zu verbessern.

Dies kann mit CVD-Verfahren geschehen (PECVD, APVCD, LPCVD), aber auch durch Kathodenzerstäubung oder anderen PVD-Verfahren. Auch die Verwendung anderer Schichten oder Schichtsysteme, wie beispielsweise Siliziumoxid, Siliziumoxinitrid, Siliziumcarbid, Aluminiumoxid, amorphem Silizium, sowie anderen dielektrischen Schichten oder Schichtsystemen aus diesen ist möglich.

Das Resultat ist in Figur 1c dargestellt.

Anschließend wird zusätzlich auf der Rückseite auf die Siliziumoxidschicht 5b eine weitere dielektrische Schicht 5d abgeschieden. Die Abscheidung erfolgt mittels plasmaunterstützter Gasphasenabscheidung. Diese weitere dielektrische Schicht ist als Siliziumoxidschicht (wobei hier das Verhältnis von Silizium zu Sauerstoff von dem von thermischem Siliziumoxid abweicht) ausgebildet und bewirkt, dass sich in Kombination mit dem auf diese Schicht aufgebrachten Rückseitenkontaktmetall ein besserer dielektrischer Spiegel ausbildet und dass sich ohne die lokale Kontaktierung kein elektrischer Kontakt zwischen Siliziumsubstrat und Metall ausbildet. Ebenso ist die Ausbildung dieser Schicht als Siliziumnitridschicht, Aluminiumoxid, Siliziumcarbid, amorphem Silizium, Siliziumoxinitrid und anderen dielektrischen Schichten oder Schichtsystemen aus diesen möglich.

Anschließend erfolgt in einem Verfahrensschritt C ein Aufbringen einer kammartigen ausgebildeten metallischen Emitterkontaktstruktur 6 auf die Vorderseite 2 des Halbleitersubstrates sowie einer metallischen Basiskontaktstruktur 7 auf der Rückseite des Halbleitersubstrates. Die Kontaktstruktur auf der Rückseite des Halbleitersubstrates ist mittels lokaler Aufschmelzung durch einen Laser ausgebildet, wie in E. Schneiderlöchner et al. Laser-fired rear contacts for crystalline silicon solar cells. Progress in Photovoltaics: Research and Applications 10 (2002) 29-34. beschrieben. Hierdurch ist in einfacher Weise eine großflächige Passivierung und lokale Kontaktierung der Basis des Halbleitersubstrates durch die rückseitigen lokalen Kontaktpunkte erzielbar.

Vorzugsweise wird die Struktur anschließend einem Temperaturschritt zwischen 200°C und 600°C ausgesetzt, da dies die Oberflächenpassivierung der Oxidschichten in einem verbessert. Dieser Temperaturschritt findet bevorzugt in inerter Atmosphäre, beispielsweise Stickstoff- oder Argongas, oder in reduzierender Atmosphäre, beispielsweise einem Gemisch aus Stickstoff- uns Wasserstoffgas, statt.

Das Ergebnis ist in Figur 1d dargestellt.

## Patentansprüche

1. Verfahren zur Herstellung einer photovoltaischen Solarzelle, folgende Verfahrensschritte umfassend:
A Texturieren einer Vorderseite (2) eines SiliziumHalbleitersubstrates (1), welches dotiert ist mit einem Basisdotierungstyp,
B Erzeugen mindestens einer selektiven Dotierstruktur an der Vorderseite (2) des Halbleitersubstrates (1), indem an der Vorderseite (2) mindestens ein flächiger Niedrigdotierbereich (4) mit einem ersten Dotierprofils in dem Halbleitersubstrat (1) erzeugt und innerhalb des ersten Niedrigdotierbereiches mindestens ein lokaler Hochdotierbereich (3) eines zweiten Dotierprofils erzeugt wird, wobei der Niedrigdotierbereich (4) und der Hochdotierbereich (3) jeweils mit einem Emitterdotierungstyps, welcher entgegengesetzt zu dem Basisdotierungstyp ist, ausgebildet werden und der Hochdotierbereich (3) mit einem niedrigeren Querleitungswiderstand ausgebildet wird als der Niedrigdotierungsbereich und C Aufbringen mindestens einer metallischen Emitterkontaktstruktur (6) mittelbar oder unmittelbar auf der Vorderseite (2) des Halbleitersubstrates, zumindest teilweise an den Bereichen lokaler Hochdotierung, wobei die Emitterkontaktstruktur elektrisch leitend mit dem Hochdotierbereich (3) verbunden wird und Aufbringen mindestens einer metallischen Basiskontaktstruktur (7) mittelbar oder unmittelbar auf der Rückseite des Halbleitersubstrates, wobei die Basiskontaktstruktur mit einem Bereich des Halbleitersubstrates des Basisdotierungstyps elektrisch leitend verbunden wird,
wobei zwischen den Verfahrensschritten B und C, gegebenenfalls unter Zwischenschaltung weiterer Zwischenschritte, in einem Verfahrensschritt B1 auf Vorder- und Rückseite des Halbleitersubstrates gleichzeitig jeweils eine Siliziumoxidschicht (5a, 5b) mittels thermischer Oxidation erzeugt wird, wobei zumindest die Vorderseitensiliziumoxidschicht mit einer Dicke kleiner 150 nm erzeugt wird,
wobei die Siliziumoxidschichten (5a, 5b) auf Vorder- und Rückseite nach Erzeugen der mindestens einen selektiven Dotierstruktur erzeugt werden und
wobei die Siliziumoxidschichten (5a, 5b) auf Vorder- und Rückseite in den auf Verfahrensschritt B1 nachfolgenden Verfahrensschritten nicht wieder entfernt werden,
**dadurch gekennzeichnet,**
**dass** zwischen Verfahrensschritt B und Verfahrensschritt B1 eine oberflächennahe Schicht mindestens auf der Vorderseite des Substrats entfernt wird.

2. Verfahren nach Anspruch 1,
**dadurch gekennzeichnet,**
**dass** in Verfahrensschritt B1 die Siliziumoxidschicht (5b) auf der Rückseite mit einer Dicke aufgebracht wird, die um weniger als 10 nm von der Dicke der Siliziumoxidschicht (5a) auf der Vorderseite (2) abweicht.

3. Verfahren nach einem der vorangegangenen Ansprüche,
dass in Verfahrensschritt B1 die Vorderseitenoxidschicht (5a) derart erzeugt wird, dass die Oberflächendotierkonzentration des Niedrigdotierbereiches an der Vorderseite (2) weniger als 4x10²⁰ cm⁻³, bevorzugt weniger als 2x10²⁰ cm⁻³, insbesondere weniger als 1x10²⁰cm⁻³, weiter bevorzugt weniger als 5x10¹⁹cm⁻³ beträgt.

4. Verfahren nach einem der vorangegangnen Ansprüche,
**dadurch gekennzeichnet,**
**dass** in Verfahrensschritt B1 an der Vorderseite (2) des Halbleitersubstrates eine Schicht mit einer Dicke zwischen 2 nm und 100 nm in Siliziumoxid umgewandelt wird.

5. Verfahren nach einem der vorangegangenen Ansprüche,
**dadurch gekennzeichnet,**
**dass** in Verfahrenschritt B1 die Siliziumoxidschichten an Vorder- und Rückseite für eine erste vorgegebene Zeitdauer mit einer ersten Wachstumsrate und für eine zweite vorgegebene Zeitdauer mit einer zweiten, gegenüber der ersten größeren Wachstumsrate erzeugt werden.

6. Verfahren nach einem der vorangegangenen Ansprüche,
**dadurch gekennzeichnet,**
**dass** in Verfahrensschritt B1 für eine erste vorgegebene Zeitdauer die thermische Oxidation in einer Gasatmosphäre mit weniger als 10 % Sauerstoffgasanteil erfolgt und anschließend der Sauerstoffanteil erhöht wird.

7. Verfahren nach einem der vorangegangenen Ansprüche,
**dadurch gekennzeichnet,**
**dass** vor Verfahrensschritt B1, vorzugsweise zwischen Verfahrensschritt A und Verfahrensschritt B1, insbesondere bevorzugt zwischen Verfahrensschritt B und Verfahrenschritt B1, Unebenheiten an der rückseitigen Oberfläche des Halbleitersubstrates eingeebnet oder zumindest verringert werden.

8. Verfahren nach einem der vorangegangenen Ansprüche,
**dadurch gekennzeichnet,**
**dass** zwischen Verfahrensschritt B und Verfahrensschritt B1 eine oberflächennahe Schicht mindestens auf der Vorderseite des Substrats entfernt wird, mit einer Dicke im Bereich 1 nm bis 300 nm.

9. Verfahren nach einem der vorangegangenen Ansprüche,
**dadurch gekennzeichnet,**
**dass** in Verfahrensschritt B die selektive Emitterstruktur folgende Verfahrensschritte umfassend erzeugt wird:
Ba Aufbringen einer Dotierstoff haltenden Dotierschicht auf die Vorderseite (2) des Halbleitersubstrates,
Bb lokales Erhitzen eines Schmelzbereiches der Dotierschicht und eines unterhalb der Dotierschicht liegenden Schmelzbereiches des Halbleitersubstrates, derart, dass sich in einem lokalen Bereich (H) kurzzeitig eine Schmelzmischung aus zumindest dem Schmelzbereich der Dotierschicht und dem Schmelzbereich des Halbleitersubstrates bildet, wobei mittels flüssig-flüssig Diffusion Dotierstoff aus der Dotierschicht in das aufgeschmolzene Halbleitersubstrat (1) diffundiert, so dass nach Erstarren der Schmelzmischung der Hochdotierungsbereich (3) erzeugt ist,
Bc Erzeugen des flächigen Niedrigdotierbereiches (4), indem das Halbleitersubstrat (1) global erwärmt wird, derart, dass Dotierstoff aus der Dotierschicht in das Halbleitersubstrat (1) diffundiert und
Bd Entfernen der Dotierschicht,
wobei die Verfahrensschritte in der Abfolge Ba,Bb,Bc,Bd oder Ba,Bc,Bb,Bd ausgeführt werden, insbesondere,
**dass** die Verfahrensschritte Ba bis Bd ohne Zwischenschaltung von Maskierungsschritten ausgeführt werden.

10. Verfahren nach Anspruch 9,
**dadurch gekennzeichnet,**
**dass** die Dotierschicht eine Dicke zwischen 10 nm und 1 µm, bevorzugt zwischen 10 nm und 500 nm, im Weiteren bevorzugt zwischen 10 nm und 100 nm aufweist.

11. Verfahren nach einem der Ansprüche 9 bis 10,
**dadurch gekennzeichnet,**
**dass** die Dotierschicht (2) Dotierstoff in einer Konzentration von mindestens 1 Gewichtsprozent, bevorzugt mindestens 4 Gewichtsprozent, im Weiteren bevorzugt im Bereich von 6 bis 10 Gewichtsprozent enthaltend aufgebracht wird.

12. Verfahren nach einem der Ansprüche 9 bis 11,
**dadurch gekennzeichnet,**
**dass** in Verfahrensschritt Ba die Dotierschicht die gesamte Vorderseite (2) des Halbleitersubstrates bedeckend aufgebracht wird.

13. Verfahren nach einem der Ansprüche 9 bis 12,
**dadurch gekennzeichnet,**
**dass** in Verfahrensschritt Bb das lokale Aufschmelzen mittels lokaler Erhitzung durch einen Laser erfolgt und/oder
**dass** in Verfahrensschritt Bb zum lokalen Aufschmelzen des Halbleitersubstrates eine Erwärmung auf mindestens 1410°C erfolgt.

14. Verfahren nach einem der Ansprüche 9 bis 13,
**dadurch gekennzeichnet,**
**dass** Verfahrensschritte Ba und Bc simultan in einem einzigen Verfahrensschritt ausgeführt werden.

## Claims

1. Process for the production of a photovoltaic solar cell, comprising the following process steps:
A texturing of a front side (2) of a silicon semiconductor substrate (1) which has been doped with a base doping type,
B creation of at least one selective doping structure on the front side (2) of the semiconductor substrate (1) by creating on the front side (2) at least one planar low-doping region (4) having a first doping profile in the semiconductor substrate (1) and creating within the first low-doping region at least one local high-doping region (3) of a second doping profile, the low-doping region (4) and the high-doping region (3) each being formed with an emitter doping type which is opposite to the base doping type, and the high-doping region (3) being formed with a lower cross-conduction resistance than the low-doping region, and
C application of at least one metallic emitter contact structure (6) indirectly or directly to the front side (2) of the semiconductor substrate, at least partly in the regions of local high doping, the emitter contact structure being electrically conductively connected to the high-doping region (3) and
application of at least one metallic base contact structure (7) indirectly or directly to the rear side of the semiconductor substrate, the base contact structure being electrically conductively connected to a region of the semiconductor substrate of the base doping type,
wherein between process steps B and C, optionally with interposition of further intermediate steps, in a process step B1 a silicon oxide layer (5a, 5b) is created simultaneously on the front and rear sides of the semiconductor substrate by means of thermal oxidation, with at least the front-side silicon oxide layer being created in a thickness of less than 150 nm,
wherein the silicon oxide layers (5a, 5b) on the front and rear sides are created after the creation of the least one selective doping structure and
wherein the silicon oxide layers (5a, 5b) on the front and rear sides are not removed again in the process steps following process step B1,
**characterised in that**
between process step B and process step B1 a layer that is close to the surface is removed at least on the front side of the substrate.

2. Process according to claim 1,
**characterised in that**
in process step B1, the silicon oxide layer (5b) is applied to the rear side in a thickness that differs from the thickness of the silicon oxide layer (5a) on the front side (2) by less than 10 nm.

3. Process according to either one of the preceding claims,
**characterised in that**
in process step B1, the front-side oxide layer (5a) is created in such a way that the surface doping concentration of the low-doping region on the front side (2) is less than 4x10²⁰ cm⁻³, preferably less than 2x10²⁰ cm⁻³, especially less than 1x10²⁰ cm⁻³, more preferably less than 5x10¹⁹ cm⁻³.

4. Process according to any one of the preceding claims,
**characterised in that**
in process step B1, on the front side (2) of the semiconductor substrate a layer having a thickness of between 2 nm and 100 nm is converted into silicon oxide.

5. Process according to any one of the preceding claims,
**characterised in that**
in process step B1, the silicon oxide layers on the front and rear sides are created for a first predetermined period at a first growth rate and for a second predetermined period at a second growth rate that is greater than the first growth rate.

6. Process according to any one of the preceding claims,
**characterised in that**
in process step B1, for a first predetermined period the thermal oxidation is effected in a gas atmosphere having a proportion of oxygen gas of less than 10 % and then the proportion of oxygen is increased.

7. Process according to any one of the preceding claims,
**characterised in that**
before process step B1, preferably between process step A and process step B1, especially preferably between process step B and process step B1, surface irregularities on the rear-side surface of the semiconductor substrate are levelled or at least reduced.

8. Process according to any one of the preceding claims,
**characterised in that**
between process step B and process step B1, at least on the front side of the substrate a layer that is close to the surface is removed, with a thickness in the range of from 1 nm to 300 nm.

9. Process according to any one of the preceding claims,
**characterised in that**
in process step B the selective emitter structure is created, comprising the following process steps:
Ba application of a dopant-containing doping layer to the front side (2) of the semiconductor substrate,
Bb local heating of a melt region of the doping layer and of a melt region of the semiconductor substrate, which melt region is located below the doping layer, in such a way that in a local region (H) there is briefly formed a molten mixture of at least the melt region of the doping layer and the melt region of the semiconductor substrate, wherein dopant diffuses from the doping layer into the molten semiconductor substrate (1) by means of liquid-liquid diffusion so that after the molten mixture has solidified the high-doping region (3) is created,
Bc creation of the planar low-doping region (4) by global heating of the semiconductor substrate (1) in such a way that dopant diffuses from the doping layer into the semiconductor substrate (1) and
Bd removal of the doping layer,
wherein the process steps are carried out in the sequence Ba, Bb, Bc, Bd or Ba, Bc, Bb, Bd; especially
process steps Ba to Bd are carried out without interposition of masking steps.

10. Process according to claim 9,
**characterised in that**
the doping layer has a thickness between 10 nm and 1 µm, preferably between 10 nm and 500 nm, more preferably between 10 nm and 100 nm.

11. Process according to either one of claims 9 and 10,
**characterised in that**
the doping layer (2) is applied so as to contain dopant in a concentration of at least 1 % by weight, preferably at least 4 % by weight, more preferably in the range of from 6 to 10 % by weight.

12. Process according to any one of claims 9 to 11,
**characterised in that**
in process step Ba, the doping layer is applied so as to cover the entire front side (2) of the semiconductor substrate.

13. Process according to any one of claims 9 to 12,
**characterised in that**
in process step Bb, the local melting is effected by means of local heating by a laser and/or
in process step Bb, for local melting of the semiconductor substrate, heating to at least 1410°C is effected.

14. Process according to any one of claims 9 to 13,
**characterised in that**
process steps Ba and Bc are carried out simultaneously in a single process step.

## Revendications

1. Procédé de fabrication d'une cellule solaire photovoltaïque, comprenant les étapes suivantes :
A texturation d'une face avant (2) d'un substrat semi-conducteur en silicium (1), lequel est dopé avec un type de dopage de base,
B production d'au moins une structure de dopage sélective sur la face avant (2) du substrat semi-conducteur (1) en produisant sur la face avant (2) au moins une zone faiblement dopée (4) plane présentant un premier profil de dopage dans le substrat semi-conducteur (1) et à l'intérieur de la première zone faiblement dopée au moins une zone fortement dopée (3) locale présentant un deuxième profil de dopage, la zone faiblement dopée (4) et la zone fortement dopée (3) étant conçues chacune avec un type de dopage d'émetteur, lequel est opposé au type de dopage de base, et la zone fortement dopée (3) étant réalisée avec une plus faible résistance de ligne transversale que la zone faiblement dopée et
C application d'au moins une structure de contact d'émetteur métallique indirectement ou directement sur la face avant (2) du substrat semi-conducteur, au moins en partie sur les zones de fort dopage local, laquelle structure de contact d'émetteur est reliée de manière électroconductrice à la zone fortement dopée (3), et
application d'au moins une structure de contact de base métallique (7) indirectement ou directement sur la face arrière du substrat semi-conducteur, laquelle structure de contact de base est reliée de manière électroconductrice à une zone du substrat semi-conducteur du type de dopage de base,
entre les étapes de procédé B et C, le cas échéant en intercalant d'autres étapes intermédiaires, une couche d'oxyde de silicium (5a, 5b) étant chaque fois produite simultanément par oxydation thermique sur la face avant et la face arrière du substrat semi-conducteur dans une étape de procédé B1, au moins la couche d'oxyde de silicium de la face avant étant produite avec une épaisseur inférieure à 150 nm,
les couches d'oxyde de silicium (5a, 5b) sur la face avant et la face arrière étant produites après production de ladite au moins une structure de dopage sélective et les couches d'oxyde de silicium (5a, 5b) sur la face avant et la face arrière n'étant plus éliminées dans les étapes de procédé qui suivent l'étape de procédé B1, **caractérisé en ce**
**qu'**entre l'étape de procédé B et l'étape de procédé B1, une couche proche de la surface est éliminée au moins sur la face avant du substrat.

2. Procédé selon la revendication 1,
**caractérisé en ce**
**qu'**à l'étape de procédé B1, la couche d'oxyde de silicium (5b) est appliqué sur la face arrière avec une épaisseur qui diffère de moins de 10 nm de l'épaisseur de la couche d'oxyde de silicium (5a) sur la face avant (2).

3. Procédé selon l'une des revendications précédentes,
**caractérisé en ce**
**qu'**à l'étape de procédé B1, la couche d'oxyde sur la face avant (5a) est produite de telle façon que la concentration de dopage superficielle de la zone faiblement dopée sur la face avant (2) est inférieure à 4×10²⁰ cm⁻³, de préférence inférieure à 2×10²⁰ cm⁻³, en particulier inférieure à 1×10²⁰ cm⁻³, plus préférentiellement inférieure à 5×10¹⁹ cm⁻³.

4. Procédé selon l'une des revendications précédentes,
**caractérisé en ce**
**qu'**à l'étape de procédé B1, une couche d'une épaisseur comprise entre 2 nm et 100 nm est transformée en oxyde de silicium sur la face avant (2) du substrat semi-conducteur.

5. Procédé selon l'une des revendications précédentes,
**caractérisé en ce**
**qu'**à l'étape de procédé B1, les couches d'oxyde de silicium sur la face avant et la face arrière sont produites pendant une première durée prédéfinie à un premier taux de croissance et pendant une deuxième durée prédéfinie à un deuxième taux de croissance, supérieur au premier.

6. Procédé selon l'une des revendications précédentes,
**caractérisé en ce**
**qu'**à l'étape de procédé B1, pendant une première durée prédéfinie, l'oxydation thermique a lieu dans une atmosphère gazeuse contenant moins de 10 % de gaz oxygène et ensuite la proportion d'oxygène est augmentée.

7. Procédé selon l'une des revendications précédentes,
**caractérisé en ce**
**qu'**avant l'étape de procédé B1, de préférence entre l'étape de procédé A et l'étape de procédé B1, en particulier de préférence entre l'étape de procédé B et l'étape de procédé B1, les irrégularités sur la surface arrière du substrat semi-conducteur sont aplanies ou au moins réduites.

8. Procédé selon l'une des revendications précédentes,
**caractérisé en ce**
**qu'**entre l'étape de procédé B et l'étape de procédé B1, une couche proche de la surface est éliminée au moins sur la face avant du substrat, sur une épaisseur comprise entre 1 nm et 300 nm.

9. Procédé selon l'une des revendications précédentes,
**caractérisé en ce**
**qu'**à l'étape de procédé B, la production de la structure d'émetteur sélective comprend les étapes de procédé suivantes :
Ba application d'une couche de dopage contenant un agent de dopage sur la face avant (2) du substrat semi-conducteur,
Bb chauffage local d'une zone de fusion de la couche de dopage et d'une zone de fusion du substrat semi-conducteur située sous la couche de dopage, de façon qu'il se forme dans une zone locale (H) temporairement un mélange fondu d'au moins la zone de fusion de la couche de dopage et la zone de fusion du substrat semi-conducteur, à l'occasion de quoi l'agent de dopage diffuse par diffusion liquide-liquide de la couche de dopage dans le substrat semi-conducteur (1) fondu, de sorte qu'après solidification du mélange fondu la zone fortement dopée (3) soit produite,
Bc production de la zone faiblement dopée (4) plane en chauffant globalement le substrat semi-conducteur (1), de façon que l'agent de dopage diffuse de la couche de dopage dans le substrat semi-conducteur (1) et
Bd élimination de la couche de dopage,
les étapes de procédé étant exécutées dans l'ordre Ba, Bb, Bc, Bd ou Ba, Bc, Bb, Bd, en particulier
**que** les étapes de procédé Ba à Bd sont exécutées sans intercalation d'étapes de masquage.

10. Procédé selon la revendication 9,
**caractérisé en ce**
**que** la couche de dopage présente une épaisseur comprise entre 10 nm et 1 µm, de préférence entre 10 nm et 500 nm, plus préférentiellement entre 10 nm et 100 nm.

11. Procédé selon l'une des revendications 9 à 10,
**caractérisé en ce**
**que** la couche de dopage (2) appliquée contient un agent de dopage dans une concentration d'au moins 1 pour cent en poids, de préférence d'au moins 4 pour cent en poids, plus préférentiellement dans la plage de 6 à 10 pour cent en poids.

12. Procédé selon l'une des revendications 9 à 11,
**caractérisé en ce**
**qu'**à l'étape de procédé Ba, la couche de dopage est appliquée de façon à recouvrir toute la face avant (2) du substrat semi-conducteur.

13. Procédé selon l'une des revendications 9 à 12,
**caractérisé en ce**
**qu'**à l'étape de procédé Bb, la fusion locale par chauffage local est effectuée au moyen d'un laser et/ou
**qu'**à l'étape de procédé Bb, un chauffage à au moins 1410 °C est effectué pour la fusion locale du substrat semi-conducteur.

14. Procédé selon l'une des revendications 9 à 13,
**caractérisé en ce**
**que** les étapes de procédé Ba et Bc sont exécutées simultanément en une seule étape de procédé.
